# EUROPEAN PATENT SPECIFICATION

(11) **EP 2 351 872 B1**
(45) Date of publication and mention of the grant of the patent: **09.06.2021**
(21) Application number: 09817921.1
(22) Date of filing: 05.10.2009
(51) Int. Cl.: C23C 18/00, C23C 18/06, C23C 18/12, C23C 18/14, H05K 3/10, H01L 27/12, H05K 1/16

(54) **TREATMENT METHOD USING PLASMA**
BEHANDLUNGSVERFAHREN MIT PLASMA
PROCÉDÉ DE TRAITEMENT UTILISANT DU PLASMA

(30) Priority: 03.10.2008 JP 2008258678
(43) Date of publication of application: 03.08.2011
(73) Proprietor: Miyahara, Hidekazu, Tokyo 124-0024 (JP); Okino, Akitoshi, Kanagawa 224-0032 (JP)
(72) Inventor: Miyahara, Hidekazu, Tokyo 124-0024 (JP); Okino, Akitoshi, Kanagawa 224-0032 (JP)
(74) Representative: Grünecker Patent- und Rechtsanwälte PartG mbB
(86) International application number: PCT/JP2009/067341
(87) International publication number: WO 2010/038894

(56) References cited:
- EP-A1- 1 617 467
- EP-A2- 1 323 846
- JP-A- 2003 324 099
- JP-A- 2005 026 175
- JP-A- 2006 096 577
- JP-A- 2006 162 754
- US-A1- 2002 190 251
- Z Fang ET AL: "Formation of hydrophobic coating on glass surface using atmospheric pressure non-thermal plasma in ambient air", Journal of Physics D: Applied Physics, vol. 37, no. 16, 29 July 2004 (2004-07-29) , pages 2261-2266, XP055570298, GB ISSN: 0022-3727, DOI: 10.1088/0022-3727/37/16/007

## Description

### TECHNICAL FIELD

The present invention relates to treatment of a base material using plasma.

### BACKGROUND ART

Surface treatment and surface modification using plasma has a relatively long history in the semiconductor industry, and in the manufacturing of advanced film materials and the like . For example, forming a circuit pattern on a silicon wafer, which is a semiconductor material, by the silicon wafer being inserted into low-pressure plasma generated within a vacuum chamber, and a gas having a high etching capability, such as CF4, being incorporated into the plasma, is used even today as an essential process in semiconductor manufacturing.

In recent years, research into incorporating a gas, such as propylene, into plasma generated under atmospheric pressure, irradiating the plasma onto fiber, paper, glass, or the like, and generating an extremely thin polymer film on the surface thereof, thereby achieving strong water repellency, research into irradiating plasma containing silane gas onto a resin surface and forming a glass-like thin film, thereby increasing the hardness of the resin surface, and the like are in progress.

However, in conventional surface treatment techniques using plasma, a gas or the like serving as a material is incorporated into plasma or atmospheric gas, and a surface is filled with a specific material or the specific material is deposited onto the surface by chemical vapor deposition (CVD) or a similar method. Alternatively, a base-material surface is eroded by plasma, and the specific material is fixed onto the base-material surface immediately thereafter.

However, in the above-described methods , (1) only limited types of gases that do not disrupt the generation of plasma, or in other words, that do not affect plasma can be used in the process, and (2) a process for realizing a specific characteristic in only a portion of a wide area, or in other words, a process having high position resolution cannot be performed. To do so, complicated processes, such as masking using a resist, are required.

In addition, in conventional film-forming methods, for example, when a ceramic film is formed on a base material, a precursor substance is required to be applied and sintering at a high temperature is required to be performed. Therefore, application on a base material incapable of withstanding high temperatures is not possible (refer to Patent Literature 1).

### [Patent Literature]

Patent Literature 1: Japanese Patent Laid-open Publication No. 2007-175881

The document Z. Fang et al. (J. Phys. D: Appl. Phys., 37 (2004) 2261) discloses non-thermal plasma treatment of glass surface with silicone oil.

### DISCLOSURE OF INVENTION

### PROBLEM TO BE SOLVED BY THE INVENTION

(1) The present invention is to easily form various particulate substances, porous substances, or film-state substances on a base material.
(2) In addition, the present invention is to form a particulate substance, a porous substance, or a film-state substance, such as ceramic, even on a base material having low heat resistance.
(3) In addition, the present invention is to quickly generate a particulate substance, a porous substance, or a film-state substance on a base material.

### MEANS FOR SOLVING PROBLEM

(1) An embodiment of the present invention is a treatment method using plasma in which plasma is irradiated onto a precursor substance deposited on a base-material surface and a portion of the component materials of the precursor substance is removed.
(2) In addition, an embodiment of the present invention is a treatment method using plasma that includes a step of depositing a precursor substance on a base-material surface and a step of irradiating plasma onto the precursor substance, and removing a portion of the component materials of the precursor
   substance.

A treatment method according to the invention is defined in claim 1. Further advantageous embodiments are defined in dependent claims.

### EFFECT OF THE INVENTION

(1) The present invention can easily form various particulate substances, porous substances, or film-state substances on a base material.
(2) In addition, the present invention can form a particulate substance, a porous substance, or a film-state substance, such as ceramic, even on a base material having low heat resistance.
(3) In addition, the present invention can quickly generate a particulate substance, a porous substance, or a film-state substance on a base material.

### BRIEF DESCRIPTION OF DRAWINGS

Fig. 1 is an explanatory diagram of a process in which a precursor substance is uniformly deposited on a planar surface of a base material;
Fig. 2 is an explanatory diagram of a process in which a pattern of a precursor substance is deposited on the planar surface of the base material;
Fig. 3 is an explanatory diagram of a process in which a precursor substance is deposited on a granular base material;
Fig. 4 is an explanatory diagram of a process using plasma generated by a torch-type plasma generating device;
Fig. 5 is an explanatory diagram of a process using a plasma generating device for microplasma;
Fig. 6 is an explanatory diagram of a process using plasma;
Fig. 7 is an explanatory diagram of a process using another plasma;
Fig. 8 is an explanatory diagram of pattern deposition and a process using plasma;
Fig. 9 is an explanatory diagram for controlling film thickness of a deposited material using concentration difference of the precursor substance;
Fig. 10 is an explanatory diagram for controlling film thickness of a deposited material by changing coating amount;
Fig. 11 is an explanatory diagram of a process using plasma in the manufacturing of an integrated chip (IC);
Fig. 12 is a spectral diagram of a material composition;
Fig. 13 is a photograph (A) of a water droplet dropped onto the surface of a sample in which a sheet of kent paper has been coated with an alcohol dilute solution of silicone oil and irradiated with plasma thereafter; a photograph (B) of a water droplet dropped onto the surface of an unprocessed sheet of kent paper; (C) a photograph of a water droplet dropped onto the surface of a sample in which a sheet of kent paper has been irradiated with plasma;
Fig. 14 is a FTIR spectral diagram in which a to d are samples in which copper plates are respectively coated with TEOS and silicone, and irradiated with plasma thereafter; and
Fig. 15 is a FTIR spectral diagram in which a to e are samples in which a sheet of paper is coated with titanium butoxide and irradiated with plasma irradiation thereafter.

### EXPLANATIONS OF LETTERS OR NUMERALS

### BEST MODE(S) FOR CARRYING OUT THE INVENTION

The present embodiment is a treatment method that is, for example, a surface treatment using plasma in which a substance serving as a precursor, namely a precursor substance, is deposited on a base-material surface, plasma is irradiated onto the precursor substance deposited on the base-material surface, and a portion of the component materials of the precursor substance is removed, or in some instances, an additive material within the plasma or atmospheric gas is supplied. As a result of the treatment, a deposited material, such as a granular substance, a porous substance, or a film-state substance, can be formed on the base-material surface. As a result of this treatment method being used in conjunction with other surface treatment, such as ordinary CVD, a more complex film can be formed. Through this treatment method, speed can be significantly increased compared to deposition methods such as CVD and sintering methods, by simply coating a surface with a liquid and irradiating plasma onto the surface. In addition, treatment may be performed by combination of the procedures of the present invention and conventional film generating methods , such as sputtering and evaporation. Plasma used herein may be in a mostly ionized state, may mostly be neutral particles with some in an ionized state or an excited state, may not be ionized, or may be gas containing radicals, high energy particles, and reactive substances.

The present embodiment realizes a substance having a predetermined feature on a base-material surface by applying, spraying, transferring, or printing the precursor substance onto the base-material surface in advance, depositing the precursor substrate on the base-material surface by performing an appropriate process as required, and irradiating plasma onto the precursor substance thereafter, rather than introducing the precursor substance that is an agent or the like required for the treatment into the plasma and irradiated the plasma onto the base material to be treated. For example, plasma is irradiated onto the precursor substance deposited on the base-material surface. An organic material or a solvent, or in some instances, a specific element within the molecules in the precursor substance is chemically reacted and thereby removed or partially removed, and a material within the plasma is attached (in other words, oxidized, hydrogenized, hydrated, phosphatized, sulfurized, halogenated, or the like). As a result, a deposited material, such as a film, is formed on the base-material surface.

Here, the base material is in particulate form, filament form, or three-dimensional form, and may differ from the precursor substance or may be the precursor substance. In addition, the material removed from the precursor substance, or the additive material attached to the precursor substance is a material also including an element. In addition, examples of the reaction for removing a portion of the materials from the precursor substance or the reaction for adding a material to the precursor substance are a carbonization reaction, oxidation and hydrogenation reactions, an addition reaction, an elimination reaction, a displacement reaction, duplexing and multiplexing, a dissociation reaction, and various reactions of organic chemistry.

In the treatment using plasma, a treatment surface may be placed within atmospheric gas, radiation may be irradiated into the atmospheric gas or onto the base-material surface thereby generating a reactive gas, and the reactive gas may be used. Alternatively, the atmospheric gas may have a capability of becoming ionized or chemically active by the radiation on the surface of a base material or the like, and may react with the precursor substance applied on the base material. Alternatively, the radiation may contribute to plasma generation. The radiation used herein is merely required to activate gas and is widely defined. The radiation may be an electromagnetic wave such as ultra-violet ray or xray, or a particle beam such as an electron beam.

The precursor substance is merely required to be a substance capable of being deposited on the base material. The form of the substance is not an issue. The substance may be liquid, gas, foam, or powder, or a solid may be applied. Alternatively, the substance may be a suspension (slurry) of gas, liquid, solid, an emulsion, particles, or the like. Any material can be used as the precursor substance, such as an inert gas such as SF6, a high-boiling substance such as higher molecular olefin, a solid substance such as TiO₂, or an easy dissociative substance such as picric acid. The precursor substance may be chemically transformed and become a different substance. Alternatively, the precursor substance may change to different substance midway and ultimately become the same substance. In addition, as the base material, for example, metal, ceramic, fiber, plastic, vinyl, nylon, glass, resin, wood, human bone, artificial bone, skin, or teeth may be used. The deposited material may be a layer having thickness or may be an atomic level thickness. The material is, for example, a silicon film, a glass film, a photocatalyst film, a diamond-like carbon film, or a carbon nanotube film. In addition, the film is not required to have a large area and may be, for example, a single molecule. Here, deposition may be physically or mechanically bonded, or chemically bonded. Deposition is merely required to be bonded by the effect of a force of some sort, such as van der Waals force. In addition, the additive material is a material added to the precursor substance, and is a material within the plasma or a material within the atmospheric gas. The additive material may be a gas-for-plasma.

Even when an unstable chemical substance that easily decomposes or loses its characteristics when introduced into plasma is used as the precursor substance, the decomposition of the precursor substance can be suppressed by low-density or low-temperature mild plasma irradiation, such as by adjusting the distance between the plasma and the precursor substance after the precursor substance is deposited on the base material and reducing plasma density. Here, mild refers to a low density state, a low temperature state, or a low density and low temperature state.

For formation and deposition of a pattern of the precursor material, a high-precision printing technique such as inkjet printing technology is used. After high-position-resolution coating is performed, the overall base material is irradiated with plasma. As a result, a substance realizing a feature in only a specific portion that has been coated can be formed with high accuracy. In this instance, plasma irradiation itself may be performed using a low-position-resolution method or a method having no position resolution. As a result of performing treatment in this way, a high-position-resolution process can be performed without processes using resists and masking.

After the precursor substance is deposited on the overall base material, plasma having an ultra-micro volume generated by micro-plasma technology is disposed in a predetermined shape, such as in an array. The plasma is sprayed instead of an ink for inkjet printing and irradiated such as to print with plasma. As a result, a feature can be realized in only the specific portion on which plasma irradiation is performed. In other words, high-position-resolution plasma irradiation can be performed. As a result of minimizing the volume of the plasma and irradiating the plasma, a high-position-resolution process can be performed.

As described above, a high-position-resolution method may be used for the formation and deposition of the pattern of the precursor substance and for plasma irradiation. For example, as a result of heads being arranged in multiple rows in which heads in a first row irradiate a precursor substance, another precursor substance can be irradiated in a second row, plasma can be irradiated in a third row, another precursor substance can be irradiated in a fourth row, and plasma can be irradiated in a fifth row, a complicated process can be made faster, or unstable chemical substances can be applied in atmosphere, and plasma irradiation can also be performed.

The precursor substance required to realize a specific feature on a certain base material may be a substance that is harmful to the generation of plasma and that makes maintaining generation of plasma difficult. If plasma of a certain degree of density is irradiated, even when a precursor substance such as that described above is not introduced into the plasma, transition to a sufficiently chemically active state can be achieved simply by the plasma being irradiated, and reaction with other substances can be generated. When a substance that easily dissociates is introduced into the plasma, the substance is required to pass through a portion in which energy generated by the plasma is applied. In this instance, the molecule becomes dispersed in the high energy field of the plasma, and the characteristics as the molecule may not be realized again. In worst case, the molecule may become atomized, leaving nothing remaining. However, if the plasma is simply irradiated, the plasma can be irradiated under relaxed conditions in portions with low density, such as in a tip section or a peripheral section . According to the present embodiment, through combination of the various methods described above, a substance in which a feature is realized can be more accurately and efficiently formed on a base-material surface. At this time, when the base material is simultaneously heated or cooled, a more efficient and accurate film generation becomes possible.

The present embodiment can be applied to numerous fields. For example, the present invention can be used in a drug delivery system by treatment of the surface of a drug (treatment such that the drug dissolves in the intestines rather than the stomach). In addition, when a material that is difficult to bond, such as alumina, and a metal are bonded, if an alumina thin film is formed on the metal surface and alumina is further bonded on the alumina thin film, bonding can be facilitated. In other words, the alumina thin film becomes similar to a surfacer. Furthermore, a glass thin film can be formed on the paint of a compact disc (CD) or an automobile, on a lens, and the like, thereby forming a super-hard surface. As described above, application of the present embodiment has endless possibilities.

The parameters of the plasma can be adjusted regardless of the precursor substance. Therefore, parameters related to the plasma irradiation process, such as the temperature and the density of the plasma, can be set to values optimal for the precursor substance. In addition, because different deposited materials may be formed depending on the temperature of the material, the temperature at which a desired material is formed may be adjusted.

### (Regarding Coating)

When pattern formation is performed, the concentration and the coating amount of the same precursor substance may be rapidly or continuously changed. As a result of the concentration and the coating amount of the precursor substance being changed, the thickness during film formation and features can be adjusted. When different substances are applied, the concentration and the coating amount may be continuously changed. Other precursor substances may be successively applied. The solution to be applied may be that using a solvent that simply dissolves the precursor substance. In addition, a solution that has an effect of increasing or reducing chemical and physical activities of the substrate, the precursor substance and the plasma may be used. Coating may be performed a plurality of times using the same or different patterns before plasma treatment.

### (Regarding Pre-treatment)

Before application of the precursor substance, a treatment may be performed in which plasma is irradiated onto the surface of the base material in advance, thereby improving or reducing hydrophilic property, hydrophobic property, and adhesion and chemical activity between the precursor substance and the base material. Alternatively, a treatment may be performed that realizes, through plasma irradiation, a substance that attracts the precursor substance or a substance that repels the precursor substance on the base-material surface. When the above-described treatments are performed, the treatments may be performed such that the surface treatment is performed in only a desired area by forming a pattern with plasma irradiation, or forming a pattern by creating areas with and without plasma irradiation using masking. Between application of the precursor substance and a subsequent application or the plasma treatment, drying, desolvation, material addition, material removal, substance modification, and a process for physical processing may be included. Drying and desolvation is performed by air drying, temperature change, light, electromagnetic waves, gas flow, irradiation of ions and particles, and the like. In addition, a portion of the materials contained in the coating substance may be removed using a liquid such as alcohol. Material addition and material removal refers to adding and removing materials to and from the precursor substance, or the precursor substance and the base-material substance, using chemical reaction or physical reaction by gas treatment, liquid treatment, irradiation of ions and particles, and the like. Substance modification refers to modification, such as polymerization, of the precursor substance, or the precursor substance and the base-material substance, by irradiation of light, electromagnetic waves, electron rays, or ions and particles, temperature change, and the like. Physical processing refers to physically processing the precursor substance, or the precursor substance and the base-material substance, by grinding, cutting, irradiation of ions and particles, use of laser, light, electromagnetic waves, and the like. The above-described pre-treatments may be repeated.

### (Regarding Plasma Treatment)

Treatment may be performed on only the surface of the precursor substance, and the interior of the precursor substance may be untreated. After plasma treatment, coating and pre-treatment procedures, or a different plasma treatment may be repeated. Depending on the type of plasma, the precursor substance and the base-material substance can be given different effects. For example, the precursor substance is fluorinated, and the base-material is hydrogen-terminated, using HF.

### (First Embodiment)

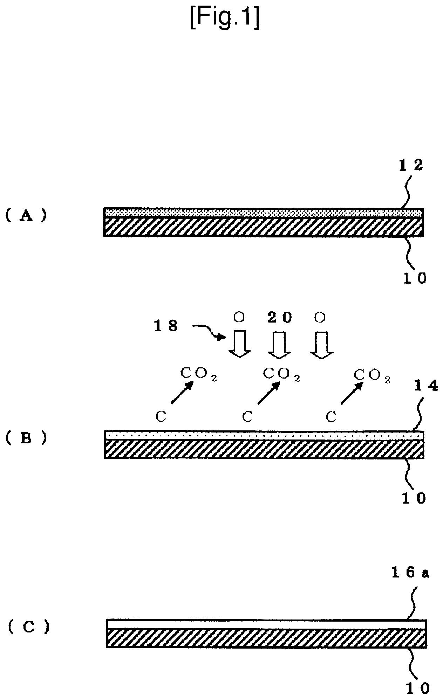

Fig. 1 shows a procedure in which a precursor substance 12 is uniformly deposited on the planar surface of a base material 10 to be treated (see FIG. 1(A)); a plasma 18 is irradiated onto the precursor substance 12, and the precursor substance 12 is reacted, thereby changing the precursor substance 12 to an intermediate substance 14 (see Fig. 1(B)); and a film 16A composed of a deposited material 16 is formed on the surface of the substrate 10 (see Fig. 1(C)). As an example of the effect of the precursor substance 12 and the deposited material 16, the following can be given. When a substance containing calcium is used as the precursor substance, the deposited material includes CaO: calcium oxide (for adsorption and/or absorption purposes and the like), CaCO₃ : gypsum (for adsorption and/or absorption purposes and the like), and the like. When a substance containing sodium is used as the precursor substance, the deposited material includes Na₂O: sodium oxide (for catalytic and adsorption and/or absorption purposes) and the like. When a substance containing boron is used as the precursor substance, the deposited material includes B₂O₅: boron oxide (for lubrication improvement), and the like. When a substance containing BN: boron nitride (for lubrication improvement) and zirconium is used as the precursor substance, the deposited material includes ZrO₂: zirconia (realization of features as heat-resistant ceramic), and the like. When a substance containing silicon is used as the precursor substance, the deposited material includes SiO₂ (realization of abrasion-resistant and scratch-resistant features as glass), and the like. When a substance containing titanium is used as the precursor substance, the deposited material includes TiO₂: titanium oxide (realization of features as a photocatalyst), and the like. When a substance containing aluminum is used as the precursor substance, the deposited material includes Al₂O₃ : aluminum oxide (realization of features as alumina and for catalytic purposes), AlCl₃: aluminum trichloride (realization of strong catalytic effect), and the like. When a substance containing zinc is used as the precursor substance, the deposited material includes ZnO: zinc oxide (realization of features as a transparent conductive material, such as a display material), and the like. When a substance containing tin is used as the precursor substance, the deposited material includes SnO: tin oxide (realization of features as a transparent conductive material), and the like. When a substance containing silver is used as the precursor substance, the deposited material includes AgO, AgO₂, and Ag₂O₃: silver oxide (for anti-bacterial and catalytic purposes), and the like.

When a substance containing barium and titanium is used as the precursor substance, the deposited material includes BaTiO3: barium titanate (realization of features as a dielectric, and applicability to electronic devices and optical filters), and the like. When a substance containing a bio-compatible material such as Cal0(PO4)6(OH)2: hydroxyapatite is used as the precursor substance, a bio-compatible film can be realized on a base material of metal and the like. In addition, for example, silicon oil and organic metals may also be applied as the precursor substance. Alternatively, elements and molecules that do not easily penetrate the base material can be forcibly disposed on the base material.

In Fig. 1, the plasma 18 indicates only an oxygen radical O. The oxygen radical O of the plasma 18 is also an additive material 20. This is an example, and various materials, such as OH, N, F, H, and high-speed electrons, can be used. The film 16A composed of the deposited material 16 that has been formed may be a new substance, or a film that is residual precursor substance. In the film 16A, a metal, a certain type of inorganic material, or an organic material may remain. As an example of the component material removed from the precursor substance, C is shown. However, various materials may be removed, such as O and H present on the surface being removed in the form of H₂O, or as O₂ as a result of collision of an oxygen atom O.

### (Second Embodiment)

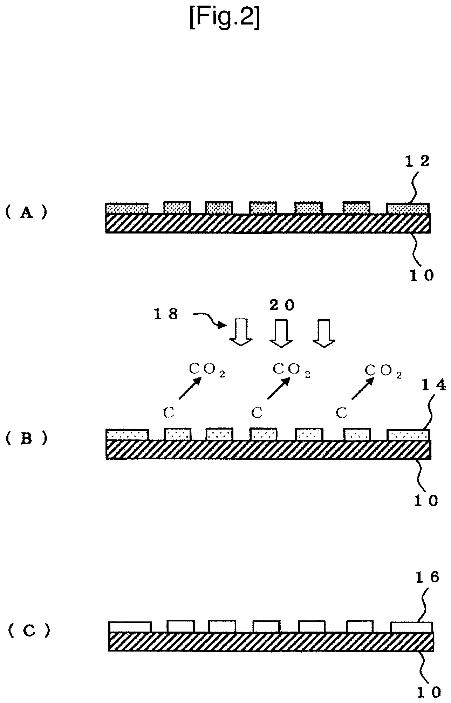

Fig. 2 is similar to the procedure shown in Fig. 1, and shows a procedure in which a pattern of the precursor substance 12 is deposited on the planar surface of the base material 10 to be treated s(see FIG. 2(A)) ; the plasma 18 is irradiated onto the precursor substance 12, and a portion of the component materials of the precursor substance 12 is removed (see FIG. 2(B)); and in some instances, the additive material 20 in the plasma is added to the precursor substance; and the deposited material 16 is formed on the substrate surface (see FIG. 2(C)). In Fig. 2, the pattern of the precursor substance 12 has a fixed width and, furthermore, only one type is shown. However, a plurality of precursor substances 12 can be disposed with arbitrary widths, and in actuality, a complex pattern can be formed. For example, through use of an inkjet printer device, a complex pattern can be formed regarding a plurality of types of precursor substances 12.

For example, a circuit pattern using the precursor substance composed of ZnO can be printed by plasma irradiation, thereby forming a transparent, conductive, thin-film circuit pattern. In addition, as a result of respective patterns of precursor substances becoming a P-type semiconductor, an N-type semiconductor, high dielectric constant material, a piezoelectric body, and the like being printed and plasma being irradiated, a circuit including various electrical elements used in a typical electrical circuit, such as resistors , diodes , transistors, solar cells, Peltier elements, piezoelectric elements, and optical switches can be formed. Because this formation does not include a sintering procedure, a crystal growth procedure, or the like, an integrated circuit can be formed on materials, such as vinyl, paper, and fabric, on which high-temperature treatment cannot be performed, in addition to metals and semiconductors. If a transparent, conductive, thin film, such as ZnO, is used in the circuit pattern, and glass or plastic is used in a substrate, a transparent integrated circuit can be formed. In addition, if the above-described procedures are repeated, a three-dimensional circuit can be configured. Moreover, after the above-described procedures, if an insulator thin film is generated and the above-described procedures are further repeated, a multi-layer circuit can also be formed. In this way, a functional thin-film circuit can be formed with minimal number of procedures, without performing procedures such as numerous resist coatings, lithography, ion injection, and etching.

### (Third Embodiment)

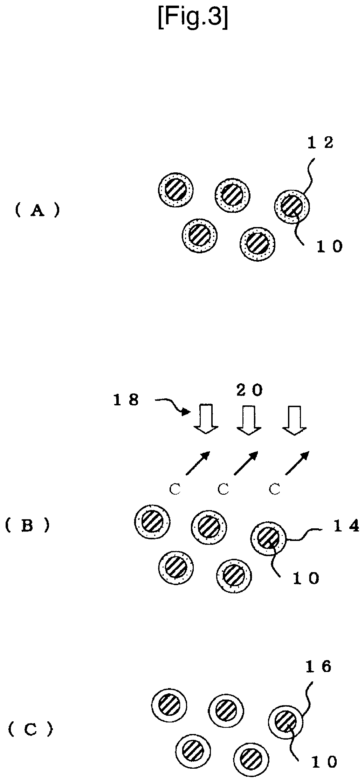

In Fig. 3, the precursor substance 12 is deposited on the base material 10 that is the form of numerous particles (see FIG. 3(A)). The particulate base material 10 on which the precursor substance 12 is deposited is passed through the plasma 18. As a result, a portion of the component materials of the precursor substance 12 is removed(see FIG. 3(B)), and in some instances, the additive material 20 in the plasma is added to the precursor substance, thereby forming the film 16A on the surface of the base material 10(see FIG. 3(C)). In Fig. 3, although the base material and the precursor substance are differentiated, the base material may be the precursor substance.

### (Fourth Embodiment)

A precursor substance is deposited on the surface of a base material to be treated that is in the form of numerous filaments or in a woven state. Although Fig. 3 describes particles, it may also be used as a drawing showing the cross-section of the filaments. Alternatively, the precursor substance is deposited on the surface of a three-dimensional base material. Plasma is irradiated onto the fibrous, woven, or three-dimensional base material on which the precursor substance has been deposited. As a result, a portion of the component materials of the precursor substance is removed, and in some instances, an additive material in the plasma is added to the precursor substance, thereby forming a film on the surface of the base material 10.

### (Example of Torch-type Plasma Generating Device)

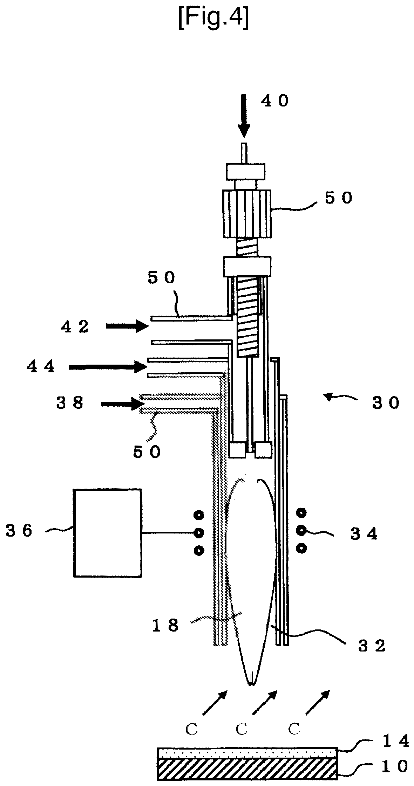

Fig. 4 shows an example of a torch-type plasma generating device 30. The plasma generating device 30 includes a plasma generating section 32 that generates plasma. A gas-for-plasma is formed into a plasma state by an electrode 34, such as a coil, disposed in the periphery of the plasma generating section 32. A power supply 36 is connected to the electrode 34. The plasma generating section 32 is cooled by a cooling gas 38. The cooling gas 38, a supplied material 40, a gas-for-plasma 42, or a support gas 44 is introduced into the plasma generating section 32 via a pipe 50. The supplied material 40 may be the additive material 20. An electrode member of the plasma generating device 30 may be any electrode member as long as it is capable of generating plasma, such as a pair of electrode members, a single electrode member (in relation to underground or in relation to space), or an electrode member capable of generating power in a space, such as an induction coil. As voltage waveform, various shapes of pulse waveforms , burst waves , modulated high-frequency waves , and the like can be used.

### (Example of Microplasma Generating Device)

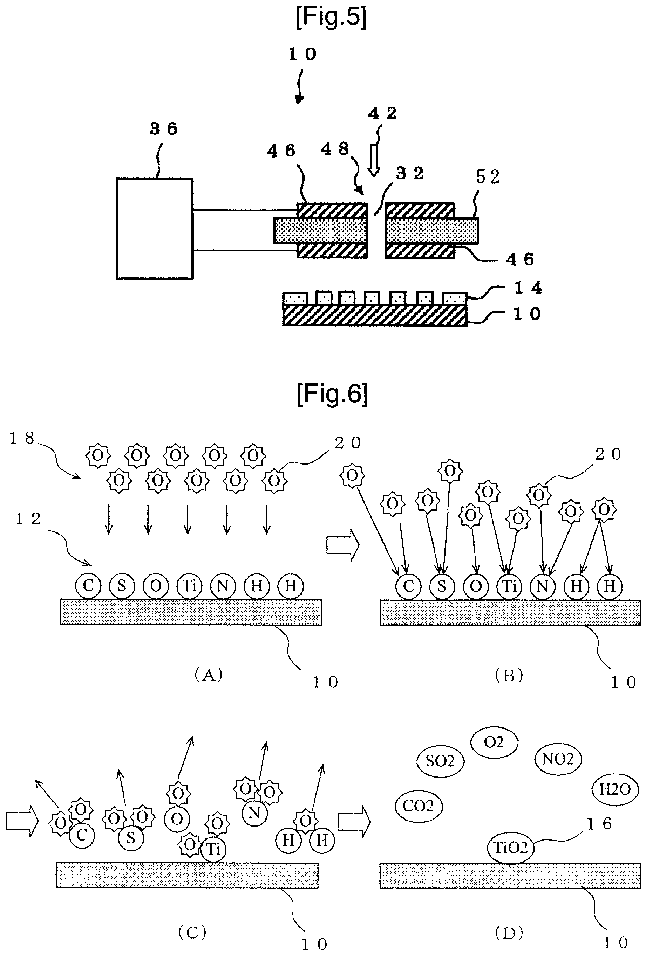

Fig. 5 shows an example of the plasma generating device 30 that generates microplasma. The plasma generating device 30 includes the plasma generating section 32, an electrode member 46 that gives power to the plasma generating section 32, and a power supply 36 that supplies power to the electrode member 46. The plasma generating section 32 for microplasma is formed in a hole portion 48 of a multi-layered body. For example, the multi-layered body has a three-layer structure in which a pair of electrode members 46 are disposed on both surfaces of an insulating body 52. The hole portion 48 penetrates the three layers. The gas-for-plasma 42 is supplied to the hole portion 48. The power supply 36 generates power. In the plasma generating device 30 that generates microplasma, for example, the diameter of the hole portion 48 of the multi-layer body is about 300µ, and the thickness of the insulating body 52 is about 1mm.

### (Example of Plasma Generating Device for Low-temperature or High-temperature Plasma)

Using the conventional plasma generating device 30 in Fig. 4 or Fig. 5, before a gas that forms plasma, namely the gas-for-plasma 42, is introduced into the plasma generating section 32, the gas-for-plasma 42 is cooled to a temperature lower than room temperature or heated to a high temperature. As a result of the temperature of the gas-for-plasma 42 being controlled in this way, the plasma 18 generated by the plasma generating section 32 has a temperature that is room temperature or below, and furthermore, a temperature that is zero or below, or a temperature higher than room temperature. In this way, the temperature of the plasma 18 can be arbitrarily controlled. As a result of use of the temperature-controlled plasma 18, various types of films, such as a film composed of a volatile material or a material that change at a high temperature, can be generated.

### (Example of Process for Removing a Portion of Component Materials)

An example of the process for removing a portion of the component materials from the precursor substance is Si- (O-CH₃)₄ (precursor substance) + O radical → SiO₂ (deposited material) + CO₂+H₂O. The component materials that are removed are CO₂ and H₂O. In this way, chemical forms change, such as C into CO₂ (boiling point: - 76° C), N into NO₂ (boiling point: 21°C), S into SO₂ (boiling point: -10°C), and O into O₂ (boiling point: - 183°C), and the materials are removed by being diffused into the atmosphere.

Fig. 6 shows an example of the process for removing a portion of the component materials. The precursor substance 12 is C, S, O, Ti, N, and H. As a result of the plasma 18 containing an oxygen radical being irradiated, C, S, O, N, and H are removed by being changed into CO₂ (boiling point: -76° C), SO₂ (boiling point: -10°C), NO₂ (boiling point: 21°C), H₂O (boiling point: 100° C), O₂ (boiling point: -183° C), and the like, and TiO₂ is deposited as the deposited material 16 on the surface of the base material 10. As the oxygen radical, there are reactive oxygen species, such as · OH, ·O₂⁻, or ·O₂H, and the like.

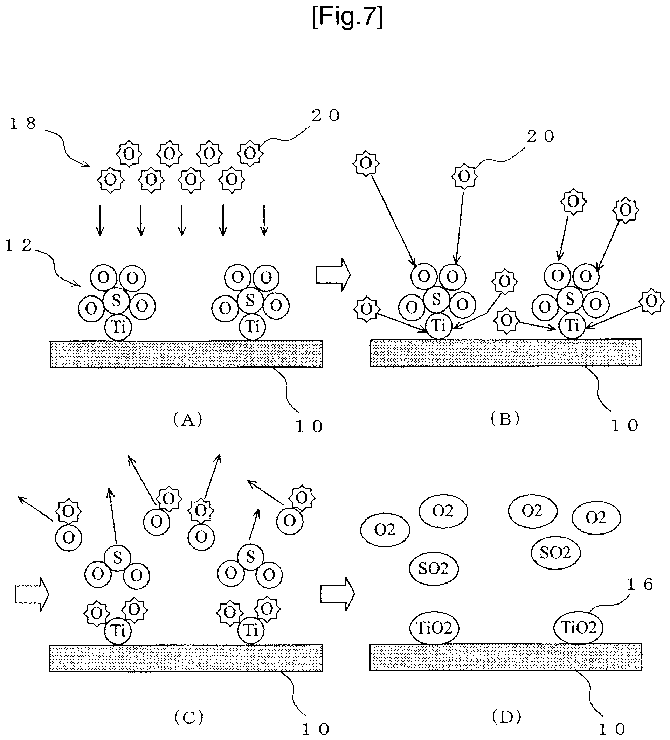

Fig. 7 shows another example of the process for removing a portion of the component materials. The precursor substance 12 is TiSO₄. As a result of the plasma 18 containing an oxygen radical being irradiated, O₂ (boiling point: -183°C) and SO₂ (boiling point: -10°C) are removed, and TiO₂ is deposited as the deposited material 16 on the substrate 16.

### (Example of Process for Supplying Additive Material)

A process for supplying an additive material is, for example, Si-(O-CH₃)₄ (precursor substance) + Cl radical·→ SiOCl (deposited material) + HCl+HClO₄. The additive material 20 is the Cl radical.

### (Formation of Pattern by Precursor Substance Spraying Device)

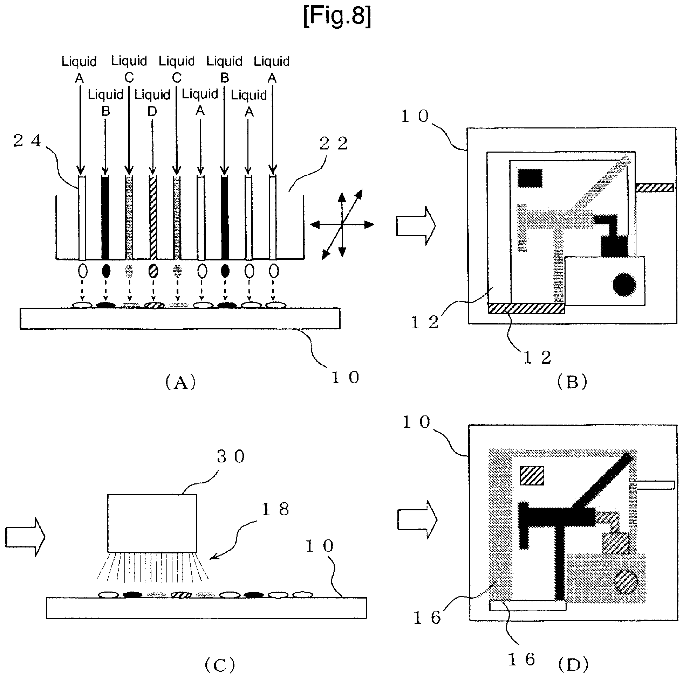

Fig. 8 shows a method for forming a pattern of the deposited material 16 by forming a pattern of the precursor substance 12 on the base material 10 using a precursor substance spraying device 22, such as an inkjet head, and irradiating the precursor substance 12 with the plasma 18. In Fig. 8(A), the precursor 12 of a plurality of types of liquid A, liquid B, liquid C, and liquid D, is irradiated onto the surface of the base material 10 from a plurality of nozzles 24, thereby forming a pattern. The precursor substance spraying device 22 moves the nozzles 24 in the XY direction and in the up/down direction (Z direction) on the surface of base material 10 and sprays the precursor substance 12. As a result, a pattern is formed such as that shown in Fig. 8(B). The precursor substance 12 of the pattern is formed by liquid A, liquid B, liquid C, and liquid D. Fig. 8(C) is a diagram in which the plasma 18 is irradiated onto the pattern. Fig. 8(D) shows the pattern of the deposited material 16 formed on the base material 10. The pattern of the deposited material 16 can have various features depending on the type of precursor substance 12, conditions of the plasma 18, and the like.

### (Formation of Pattern by Concentration Difference of Precursor Substance)

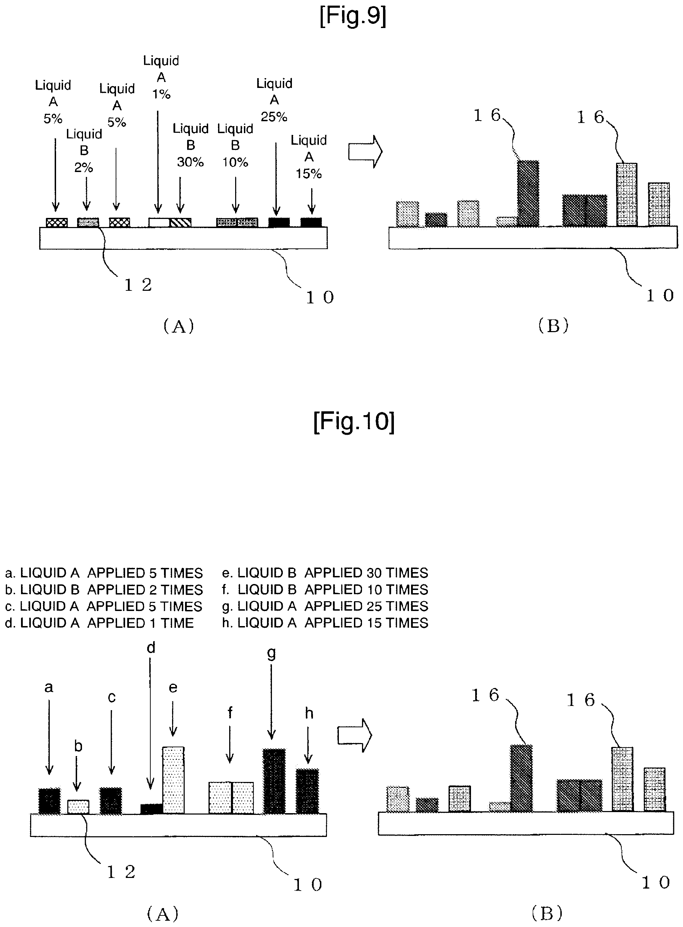

Fig. 9 shows a method in which a pattern having different concentrations of the precursor substance 12 of a plurality of types of liquid A and liquid B is formed on the base material 10 (Fig. 9(A)), the plasma 18 is irradiated onto the pattern, and the pattern of the deposited material 16 is formed having film thickness that differs with substance type (Fig. 9(B)).

### (Formation of Pattern by Difference in Number of Coatings of Precursor Substance)

Fig. 10 shows a method in which the precursor substance 12 of a plurality of types of liquid A and liquid B is applied on the base material 10 thereby forming a the plasma 18 is irradiated onto the pattern, and the pattern of the deposited material 16 is formed having film thickness that differs with substance type (Fig. 10(B)).

### (Formation of Integrated Circuit by Treatment using Plasma)

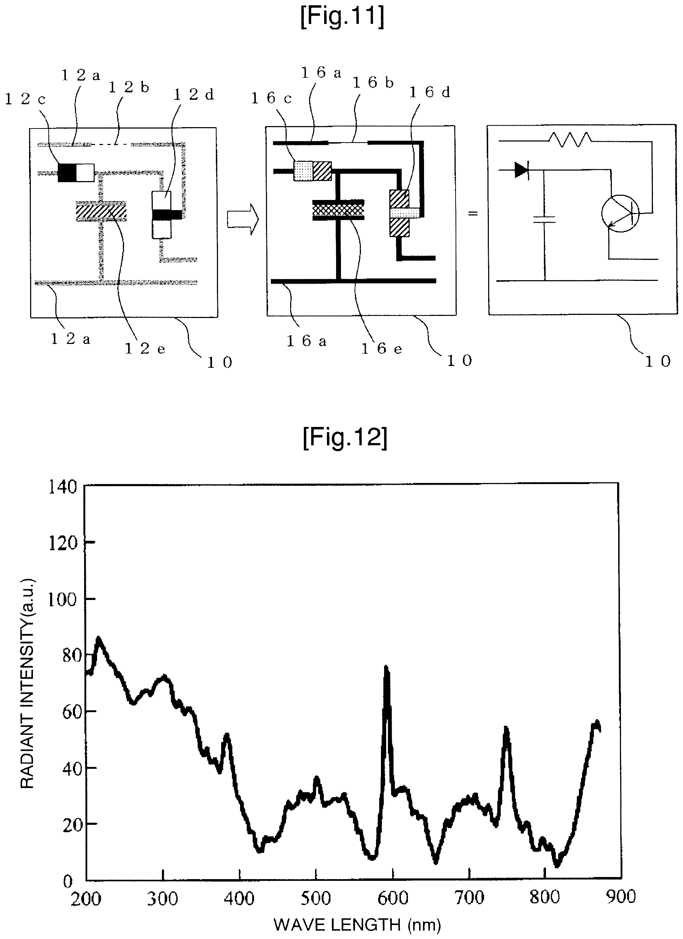

Fig. 11 shows a method for forming an integrated circuit by the treatment using plasma. Fig. 11(A) shows a pattern of an integrated circuit composed of the precursor substrate 12 on the base material 10 composed of a transparent material such as vinyl, or paper, fabric, and the like. A precursor substance 12a is a wiring portion of a precursor substance such as ZnO that becomes a transparent electrode. A precursor substance 12b is a resistor portion of a thin precursor substance such as ZnO that becomes a resistor. A precursor substance 12c indicates a PN portion in which a precursor substance that becomes an N-type semiconductor and a precursor substance that becomes a P-type semiconductor are in contact. A precursor substance 12d indicates a PNP portion or a NPN portion in which the precursor substance that becomes the P-type semiconductor, the precursor substance that becomes the N-type semiconductor, and the precursor substance that becomes the P-type semiconductor are in contact. A precursor substance 12e indicates a high-permittivity portion at which a precursor substance such as barium titanate that becomes high permittivity is in contact between a precursor substance ZnO or the like that forms parallel transparent electrodes.

As a result of plasma being irradiated onto the pattern composed of the precursor substance in Fig. 11(A), Fig. 11(B) is formed, and the transparent electrode portion operates as a wiring member 16a, the thin transparent electrode portion operates as a resistor 16b, the PN portion operates as a diode 16c, the PNP portion or the NPN portion operates as a transistor 16d, and the high-permittivity portion between the transparent electrodes operate as a capacitor 16e. Then, after a precursor substance that becomes an insulating substance is applied, if plasma is irradiated and a circuit pattern is further generated on the plasma, a multi-layer structure circuit can be formed. If all are made thin, the overall circuit can be made transparent. Because the capacitor increases capacity, the circuit may be configured to be three-dimensional using the multi-layer structure. Fig. 11(C) shows an electrical circuit diagram of the pattern in Fig. 11(B).

### [First Example] (not according to the invention)

Titanic sulfate of 1000ppm as the precursor substance 12 was applied with a thickness of 10µm on a copper plate of the base material 10, and dried and hardened by evaporation. As a result, a titanic sulfate film of about 10nm is considered to have been formed. On a sample formed in this way, atmospheric-pressure, non-equilibrium plasma was irradiated for three seconds, the plasma generated by 20L/min of helium gas, 0.6L/min of oxygen, and input power of 140W. Electron density in a plasma source is about 1x10¹⁴cm⁻³, gas temperature is about 80°C, electron temperature is about 9000°C, and atmospheric pressure is about 1atm. A large portion of the oxygen is present as an oxygen radical or as ozone. When the material composition of the surface of the sample on which plasma irradiation has been performed was evaluated using a laser Raman microscope, a spectrum such as that shown in Fig. 12 was obtained. Because peaks characteristic of anatase TiO₂ were observed at about 400nm, slightly over 500nm, and slightly over 600nm, it is confirmed that an anatase titanium oxide thin film having photocatalytic activity has been formed. As a result, a thin film of a photocatalyst composed of titanium oxide was generated on a copper surface without a sintering process being performed. At this time, the component material that has been removed is S within Ti(SO₄)₂. When a similar experiment was conducted using paper instead of the copper plate as the base material 10, a thin film composed of anatase titanium oxide was formed on the paper surface in a manner similar to that described above.

In addition, in the above-described experiment for forming the thin film composed of titanium oxide on the copper plate surface, when film formation speed was calculated, 66µm/min was obtained. Conventionally, it is known that, in an experiment for thin-film formation using titanium oxide by thermal plasma-enhanced CVD, the film formation speed becomes 4µm/min. Therefore, it is clear that, in the treatment method of the present invention, treatment can be performed at a higher speed than in the past.

### [Second Example]

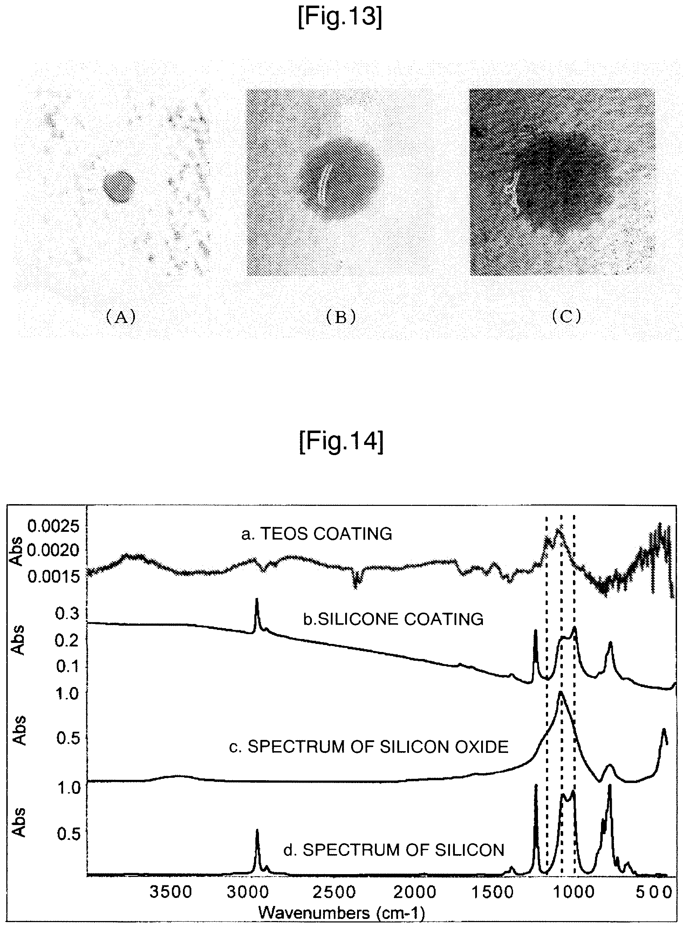

First, the following was prepared as a sample. A silicone-oil alcohol diluted solution was applied as the precursor 12 on a sheet of kent paper of the base material 10, and dried and hardened by evaporation. Then, plasma was irradiated for three seconds, the plasma generated using helium gas and oxygen gas (content of 3% in relation to the helium gas) as the gas-for-plasma 42. In addition, the following were prepared as comparison samples : an untreated sheet of kent paper, and a sheet of kent paper on which the above-described plasma was irradiated for three seconds. Then, a water droplet in which a blue dye had been dissolved was dropped onto the respective surfaces of the three samples. As a result, as shown in Fig. 13(A), water repellency was confirmed regarding the sample in which the plasma was irradiated onto the sheet of kent paper coated with the silicone-oil alcohol diluted solution. Regarding the sample in which the plasma was irradiated onto the sheet of kent paper (see Fig. 13(B)), it was confirmed that hydrophilic property improved compared to the untreated sheet of kent paper (see Fig. 13(C))

In the above-described experiment, kent paper was used as the base material 10. However, when an experiment similar to that above was performed using a non-woven fabric and a copper plate instead of the kent paper, water repellency was confirmed for both samples in which the silicone-oil alcohol diluted solution was applied to the non-woven fabric and the copper plate, and the plasma irradiated thereon.

Next, a Fourier Transform infrared (FTIR) spectrum was measured for a sample in which the silicone-oil alcohol diluted solution was applied as the precursor substance 12 on a copper plate of the base material 10, and plasma was irradiated thereafter. As the sample for the present experiment, that in which an ethanol solution containing silicone oil diluted 20 times was applied as the precursor substance 12 on the copper plate of the base material 10, and dried and hardened by evaporation, and plasma irradiation of a period of one second was repeated 20 times thereafter, was used. b in Fig. 14 shows an FTIR spectrum of a sample created in this way. The spectrum differs from the FTIR spectrum of the silicone itself (see d in Fig. 14).

From the above-described results, it has been confirmed that, by the silicone-oil alcohol diluted solution being respectively applied as the precursor substance 12 on the surfaces of a copper plate, a sheet of kent paper, and a non-woven fabric of the base material 10, and plasma being irradiated thereafter, the surface of the copper plate has water repellency, and the deposited material 16 having a chemical structure differing from silicone is formed.

In addition, when film formation speed was calculated in an experiment for forming a vitreous thin film on the surface of the copper plate, described above, 0.3µm/min was obtained. Conventionally, it is known that, in an experiment for vitreous thin-film formation by CVD, the film formation speed becomes 0.008µm/min. Therefore, it is clear that, in the treatment method of the present invention, treatment can be performed at a higher speed than in the past.

### [Third Example] (not according to the invention)

The FTIR spectrum was measured for a sample in which a concentrate solution of tetraethyl orthosilicate (TEOS) was applied as the precursor substance 12 on a copper plate of the base material 10, and plasma irradiation of a period of 60 was repeated five times thereafter. As a result, a spectrum such as that of a in Fig. 14 was obtained. Because peaks characteristic of silicon oxide were observed (see c in Fig. 14), it is confirmed that a portion of the component materials was removed from tetraethyl orthosilicate that is the precursor substance 12, and silicon oxide that is the deposited material 16 was formed on the surface of the copper plate.

### [Fourth Example] (not according to the invention)

First, a following was prepared as a sample: a titanium-butoxide ethanol diluted solution was applied as the precursor substance 12 on only the front surface side of a sheet of paper of the base material 10, and plasma irradiation of a period of 20 seconds was repeated three times thereafter. Then, the FTIR spectrum was measured for the front surface side and the back surface side of the sample.

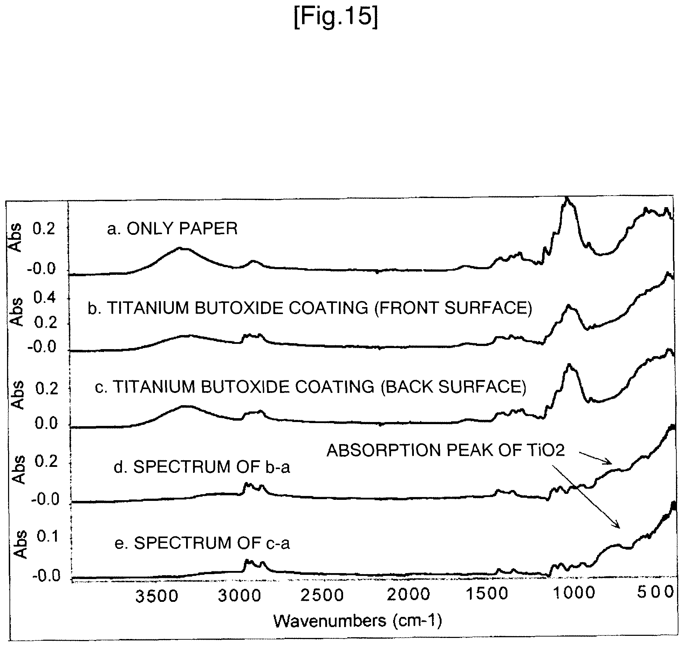

As a result, the FTIR spectrums such as b and c in Fig. 15 were respectively obtained for the front surface side and the back surface side of the sample. Difference spectrums were created (see d and e in Fig. 15) in which the FTIR spectrum of paper (see a in Fig. 15) was subtracted from the foregoing FTIR spectrums. As indicated in d and e of Fig. 15, peaks characteristic of TiO₂ were observed in both difference spectrums of the front surface side and the back surface side of the paper. Therefore, it is confirmed that a portion of the component materials was removed from titanium butoxide, and a TiO₂ thin film having photocatalytic activity was formed as the deposited material 16 on both surfaces on the front surface side and the back surface side of the paper.

The present invention is not limited to the above-described embodiment as is. In the implementation stage, constituent elements can be modified and specified without departing from the scope of the present invention as claimed. In addition ,various inventions can be formed by appropriate combinations of the plurality of constituent elements disclosed according to the above-described embodiment. For example, some constituent elements may be eliminated from all constituent elements according to the embodiment. Furthermore, constituent elements may be combined accordingly over different embodiments. In addition, various modifications can be made without departing from the scope of the present invention as claimed.

### EXPLANATION OF REFERENCE NUMBERS

- 10: base material
- 12: precursor substance
- 14: substance
- 16: deposited material
- 16A: film
- 18: plasma
- 20: additive material
- 22: precursor substance spraying device
- 24: nozzle
- 30: plasma generating device
- 32: plasma generating section
- 34: electrode
- 36: power supply
- 38: cooling gas
- 40: supply material
- 42: gas-for-plasma
- 44: support gas
- 46: electrode member
- 48: hole portion
- 50: pipe
- 52: insulating body

## Claims

1. A treatment method of deposited substance, using plasma (18) in which plasma (18) is irradiated onto a precursor substance (12) deposited on a base-material surface, and a portion of component materials of the precursor substance (12) is removed,
**characterized in that**
the precursor substance (12) consists silicone-oil or silicone-oil alcohol, and by radiating plasma (18) the portion of the component materials of the precursor substance (12) is removed and the precursor substance (12) becomes water-shedding deposited substance added with an additive material within plasma or atmospheric gas,
the treatment method comprising:
a step of depositing the precursor substance (12) only on the base-material surface formed by a substance to which the precursor substance (12) can be deposited;
a step of irradiating atmospheric-pressure plasma including oxygen onto the precursor substance (12) with a predetermined temperature which is a parameter concerning irradiation treatment, to remove the portion of the component materials and to add the additive material by controlling the temperature of gas-for-plasma (42) to lower or higher than room temperature to generate plasma (18); and
a step of removing the portion of the component materials of the precursor substance (12) and adding oxygen as the additive material to the precursor substance (12) by radiating the atmospheric-pressure plasma (18) so as to form the water-shedding deposited substance having a chemical structure differing from silicon and results the precursor substance on the base-material surface.

2. The treatment method according to claim 1, wherein the base material (10) is in particulate form, filamentous form, fabric form, non-woven fabric form or three-dimensional form.

3. The treatment method according to claim 1 or 2, wherein the precursor substance (12) is deposited on the base material (10) by coating, spraying, transfer, or printing.

## Patentansprüche

1. Behandlungsverfahren von abgeschiedener Substanz unter Verwendung von Plasma (18), bei dem Plasma (18) auf eine auf einer Basismaterialoberfläche abgeschiedene Vorläufersubstanz (12) bestrahlt wird und ein Anteil von Komponentenmaterialien der Vorläufersubstanz (12) entfernt wird,
**dadurch gekennzeichnet, dass**
die Vorläufersubstanz (12) aus Silikonöl oder Silikonölalkohol besteht, und durch Bestrahlen mit Plasma (18) der Anteil der Komponentenmaterialien der Vorläufersubstanz (12) entfernt wird und die Vorläufersubstanz (12) zu einer wasserabweisenden, abgeschiedenen Substanz wird, der ein Zusatzmaterial in Plasma oder atmosphärischem Gas zugegeben wird,
wobei das Behandlungsverfahren umfasst:
einen Schritt des Abscheidens der Vorläufersubstanz (12) nur auf der Basismaterialoberfläche, die durch eine Substanz gebildet wird, auf die die Vorläufersubstanz (12) abgeschieden werden kann;
einen Schritt des Bestrahlens der Vorläufersubstanz (12) mit einem Atmosphärendruckplasma beinhaltend Sauerstoff mit einer vorbestimmten Temperatur, die ein Parameter bezüglich Bestrahlungsbehandlung ist, um den Anteil der Komponentenmaterialien zu entfernen und das Zusatzmaterial hinzuzufügen, indem die Temperatur von Gas-für-Plasma (42) auf niedriger oder höher als Raumtemperatur kontrolliert wird, um Plasma (18) zu erzeugen; und
einen Schritt des Entfernens des Anteils der Komponentenmaterialien der Vorläufersubstanz (12) und des Hinzufügens von Sauerstoff als das Additivmaterial zu der Vorläufersubstanz (12) durch Bestrahlen mit dem Atmosphärendruckplasma (18), um so die wasserabweisende, abgeschiedene Substanz zu bilden, die eine chemische Struktur besitzt, die sich von Silizium unterscheidet und die Vorläufersubstanz auf der Basismaterialoberfläche ergibt.

2. Das Behandlungsverfahren nach Anspruch 1, wobei das Basismaterial (10) in Partikelform, Filamentform, Gewebeform, Vliesstoffform oder dreidimensionaler Form vorliegt.

3. Das Behandlungsverfahren nach Anspruch 1 oder 2, wobei die Vorläufersubstanz (12) durch Beschichten, Sprühen, Übertragen oder Drucken auf das Basismaterial (10) abgeschieden wird.

## Revendications

1. Procédé de traitement d'une substance déposée, utilisant du plasma (18), dans laquelle le plasma (18) est irradié sur une substance précurseur (12) déposée sur une surface de matériau de base, et une partie des matériaux constitutifs de la substance précurseur (12) est retirée,
**caractérisé en ce que**
la substance précurseur (12) est constituée de silicone-huile ou d'alcool silicone-huile, et en irradiant le plasma (18), la partie des matériaux constitutifs de la substance précurseur (12) est éliminée et la substance précurseur (12) devient une substance déposée par dispersion d'eau à laquelle est ajouté un matériau additif dans le plasma ou le gaz atmosphérique,
le procédé de traitement comprenant:
une étape consistant à déposer la substance précurseur (12) uniquement sur la surface de la matière de base formée par une substance sur laquelle la substance précurseur (12) peut être déposée;
une étape d'irradiation du plasma à pression atmosphérique comprenant de l'oxygène sur la substance précurseur (12) avec une température prédéterminée qui est un paramètre concernant le traitement d'irradiation, pour enlever la partie des matériaux composants et pour ajouter le matériau additif en contrôlant la température du gaz pour le plasma (42) à une température inférieure ou supérieure à la température ambiante pour générer le plasma (18); et
une étape consistant à retirer la partie des matériaux constitutifs de la substance précurseur (12) et à ajouter de l'oxygène comme matériau additif à la substance précurseur (12) en irradiant le plasma à la pression atmosphérique (18) de manière à former la substance déposée par délestage d'eau ayant une structure chimique différente de celle du silicium et à obtenir la substance précurseur sur la surface du matériau de base.

2. Procédé de traitement selon la revendication 1, dans lequel le matériau de base (10) se présente sous forme de particules, de filaments, de tissu, de non-tissé ou sous forme tridimensionnelle.

3. Procédé de traitement selon les revendications 1 ou 2, dans lequel la substance précurseur (12) est déposée sur le matériau de base (10) par revêtement, pulvérisation, transfert ou impression.
